# EUROPÄISCHE PATENTSCHRIFT

(11) **EP 1 080 491 B1**
(45) Veröffentlichungstag und Bekanntmachung des Hinweises auf die Patenterteilung: **06.08.2008**
(21) Anmeldenummer: 99953402.7
(22) Anmeldetag: 07.04.1999
(51) Int. Cl.: H01L 21/603, H01L 21/607, B23K 20/00

(54) **VERFAHREN ZUR HERSTELLUNG EINER BOND-DRAHT-VERBINDUNG**
METHOD FOR PRODUCING A WIRE BONDING CONNECTION
PROCEDE POUR REALISER UNE CONNEXION PAR MICROCABLAGE

(30) Priorität: 27.05.1998 DE 19823623
(43) Veröffentlichungstag der Anmeldung: 07.03.2001
(73) Patentinhaber: ROBERT BOSCH GMBH, 70442 Stuttgart (DE)
(72) Erfinder: WILDNER, Ingolf, D-72760 Reutlingen (DE)
(86) Internationale Anmeldenummer: PCT/DE1999/001037
(87) Internationale Veröffentlichungsnummer: WO 1999/062114

(56) Entgegenhaltungen:
- PATENT ABSTRACTS OF JAPAN vol. 013, no. 264 (E-774), 19. Juni 1989 (1989-06-19) -& JP 01 057725 A (TAIYO YUDEN CO LTD), 6. März 1989 (1989-03-06)
- PATENT ABSTRACTS OF JAPAN vol. 011, no. 143 (E-504), 9. Mai 1987 (1987-05-09) & JP 61 280626 A (SANYO ELECTRIC CO LTD), 11. Dezember 1986 (1986-12-11)
- PATENT ABSTRACTS OF JAPAN vol. 013, no. 429 (E-823), 25. September 1989 (1989-09-25) & JP 01 158742 A (SANKEN ELECTRIC CO LTD), 21. Juni 1989 (1989-06-21)
- PATENT ABSTRACTS OF JAPAN vol. 009, no. 056 (E-302), 12. März 1985 (1985-03-12) & JP 59 195836 A (SONY KK), 7. November 1984 (1984-11-07)
- PATENT ABSTRACTS OF JAPAN vol. 006, no. 072 (E-105), 7. Mai 1982 (1982-05-07) & JP 57 012530 A (HITACHI LTD), 22. Januar 1982 (1982-01-22)
- PATENT ABSTRACTS OF JAPAN vol. 013, no. 051 (E-712), 6. Februar 1989 (1989-02-06) & JP 63 244633 A (OKI ELECTRIC IND CO LTD), 12. Oktober 1988 (1988-10-12)
- PATENT ABSTRACTS OF JAPAN vol. 013, no. 574 (E-863), 19. Dezember 1989 (1989-12-19) & JP 01 239861 A (SHINKAWA LTD;OTHERS: 01), 25. September 1989 (1989-09-25)
- PATENT ABSTRACTS OF JAPAN vol. 016, no. 120 (E-1182), 26. März 1992 (1992-03-26) & JP 03 289149 A (MATSUSHITA ELECTRIC IND CO LTD), 19. Dezember 1991 (1991-12-19)
- PATENT ABSTRACTS OF JAPAN vol. 014, no. 045 (E-0880), 26. Januar 1990 (1990-01-26) & JP 01 276729 A (NEC KANSAI LTD), 7. November 1989 (1989-11-07)

## Beschreibung

Die Erfindung betrifft ein Verfahren zur Herstellung einer elektrischen Verbindung.

### Stand der Technik

Zum Herstellen einer elektrischen Verbindung zwischen wenigstens zwei Kontaktflächen ist eine Einzeldraht-Kontaktierung, ein sogenanntes Bonden, bekannt. Hierbei werden Einzeldrähte, insbesondere Gold- oder Aluminiumdrähte, mittels einer Drahtbondeinrichtung zwischen den zu kontaktierenden Kontaktflächen angeordnet. Bei dem Bonden wird der Kontaktdraht unter Einwirkung von Druckultraschall und Temperatur mit den Kontaktflächen kontaktiert. Der Verbindungsdraht wird zunächst an seinem freien Ende durch Beaufschlagung mit thermischer Energie zu einer Kugel aufgeschmolzen und dann mit einer Bondkapillare auf die erste Kontaktfläche gedrückt. Hierbei verbindet sich der Kontaktdraht mit der Kontaktfläche durch an der Grenzfläche zwischen der Kontaktfläche und dem Kontaktdraht entstehende atomare Bindungskräfte (Stoffschluß). Während des Kontaktierens mit der ersten Kontaktfläche verformt sich die zuvor angeschmolzene Kugel zu einem Nagelkopf, einem sogenannten Nailhead. Anschließend wird der Kontaktdraht mittels der Drahtbondeinrichtung zur zweiten Kontaktfläche geführt. Um einem Abreißen des Kontaktdrahtes an der ersten Kontaktstelle entgegenzuwirken, wird der Kontaktdraht hierbei in einem Bogen, einem sogenannten Loop, geführt. Anschließend wird der Kontaktdraht mittels der Drahtbondeinrichtung auf die zweite Kontaktfläche, unter erneuter Einwirkung von Druckultraschall und Temperatur, gepreßt. Hierbei erfolgt eine Einschnürung des Kontaktdrahtes, so daß dieser eine Sollbruchstelle ausbildet, an der der Kontaktdraht nach Fortführen der Drahtbondeinrichtung von -der zweiten Kontaktfläche reißt. Der Kontaktdraht ist mit der zweiten Kontaktfläche über einen sogenannten Stitch verbunden, wobei wiederum zwischen dem Kontaktdraht und der zweiten Kontaktfläche an der Grenzfläche atomare Bindungskräfte entstehen.

Bei diesem bekannten, sogenannten Ball-Wedge-Bonden (Kugel-Kontaktierung mit der ersten Kontaktfläche [Ball], Stitch-Kontaktierung mit der zweiten Kontaktfläche [Wedge]) besteht eine starke Materialabhängigkeit zwischen dem Kontaktdraht und den Kontaktflächen, damit es zur Ausbildung entsprechend großer atomarer Bindungskräfte an den Grenzflächen kommt. Insbesondere beim Kontaktieren der zweiten Kontaktfläche steht nur eine relativ geringe Flächenanbindung zwischen dem Stitch und der Kontaktfläche zur Verfügung, die insbesondere bei Kontaktflächen aus schlecht bondbaren Materialien zu Fehlkontaktierungen führen kann.

Weitere Verfahren sind in den Dokumenten JP61280626, JP3289149 und JP1158742 beschrieben.

### Vorteile der Erfindung

Das erfindungsgemäße Verfahren mit den im Anspruch 1 genannten Merkmalen bietet demgegenüber den Vorteil, daß die Kontaktsicherheit der Verbindung zwischen dem Kontaktdraht und der zweiten Kontaktfläche wesentlich verbessert ist. Dadurch, daß mittels der Drahtbondeinrichtung nach Kontaktierung der zweiten Kontaktfläche die Kontaktstelle mit einer zusätzlichen Kontaktsicherung versehen wird, wird die Kontaktsicherheit der zweiten Kontaktstelle (Stitch oder Wedge) unabhängig von der Erzeugung der atomaren Bindungskraft zwischen dem Kontaktdraht und der zweiten Kontaktfläche erhöht.

In der Erfindung ist vorgesehen, daß die zusätzliche Kontaktsicherung durch eine auf die Kontaktstelle aufgebrachte und anschließend mittels der Drahtbondeinrichtung verformte kugelförmige Ausbildung eines nach der Kontaktierung der zweiten Kontaktfläche freien Kontaktdrahtendes erfolgt. Hierdurch wird im Anschluß an die Ausbildung der elektrischen Verbindung zwischen dem Kontaktdraht und der zweiten Kontaktfläche unmittelbar nachfolgend an dem dann freien Ende des Kontaktdrahtes die Kugel (Ball) ausgebildet und diese als zusätzliche Kontaktsicherung über der Kontaktstelle angeordnet. Insbesondere ist bevorzugt, wenn die Verformung der Kugel mittels der Drahtbondeinrichtung so erfolgt, daß eine Überlappung der Kontaktstelle derart erfolgt, daß wenigstens ein, vorzugsweise zwei zusätzliche Verbindungsbereiche zwischen der zusätzlichen Kontaktsicherung und der Kontaktfläche sich ergeben. Die zusätzlichen Verbindungsbereiche haften durch erzeugte atomare Bindungskräfte an der Kontaktfläche und bilden quasi eine Zugentlastung für den an der zweiten Kontaktfläche angebondeten Kontaktdraht. Hierdurch wird ein Abreißen des Kontaktdrahtes von der zweiten Kontaktfläche mit großer Sicherheit ausgeschlossen. Ein Abreißen ist nunmehr durch die Zerreißfestigkeit des Kontaktdrahtes selber gegeben und nicht mehr durch die Haftung zwischen dem Kontaktdraht und der zweiten Kontaktfläche beeinflußt, das heißt, bevor die Kontaktstelle abreißt, reißt der Kontaktdraht selber durch.

Darüber hinaus ist in bevorzugter Ausgestaltung der Erfindung vorgesehen, daß die Herstellung der zusätzlichen Kontaktsicherung durch Einstellungen der Drahtbondeinrichtungen, insbesondere durch eine Programmierung einer entsprechender Steuerung der Drahtbondeinrichtung, exakt reproduzierbar ist. Hierdurch können bei einer Vielzahl von Kontaktierungen identische Kontaktsicherungen erzielt werden, die sich aufgrund eines vorhersagbaren reproduzierbaren Ergebnisses in einfacher Weise überprüfen lassen. Insbesondere ist bevorzugt, wenn eine optische, vorzugsweise automatische optische Sichtprüfung der Kontaktstelle erfolgt, wobei nicht exakt, das heißt entsprechend der vorgegebenen Reproduzierbarkeit erreichte Kontaktsicherungen sicher erkannt werden müssen. Hierdurch läßt sich quasi eine Null-Fehler-Rate bei der Herstellung von Kontaktierungen erreichen, die zu einer erhöhten Produktionsausbeute führen.

Durch eine nich beanspruchte Kontaktstelle wird vorteilhaft erreicht, daß eine hohe Kontaktsicherheit zwischen dem Kontaktdraht und der Kontaktfläche gegeben ist. Dadurch, daß die Kontaktstelle eine zusätzliche Kontaktsicherung umfaßt, die den Kontaktdraht im Bereich der Kontaktstelle zumindest teilweise übergreift und wenigstens eine zusätzliche Verbindungsfläche mit der Kontaktfläche ausbildet, wird vorteilhaft erreicht, daß die zur Verfügung stehende Gesamtfläche für eine Kontaktierung des Kontaktdrahtes mit der Kontaktfläche vergrößert ist, so daß die Kontaktstelle größeren mechanischen Beanspruchungen standhalten kann. Insbesondere beim Einsatz in sicherheitsrelevanten Bauteilen können durch diese Kontaktstelle elektrische Anschlüsse erhalten werden, die eine hohe Redundanz aufweisen.

Weitere vorteilhafte Ausgestaltungen der Erfindung ergeben sich aus den übrigen, in den Unteransprüchen genannten Merkmalen.

### Zeichnungen

Die Erfindung wird nachfolgend in Ausführungsbeispielen anhand der zugehörigen Zeichnungen näher erläutert. Es zeigen:
- Figuren 1a bis 1h: jeweils in schematischen Ansichten die Verfahrensschritte zur Herstellung einer elektrischen Verbindung und
- Figuren 2 bis 6: verschiedene Ausführungsformen einer Kontaktstelle.

### Beschreibung der Ausführungsbeispiele

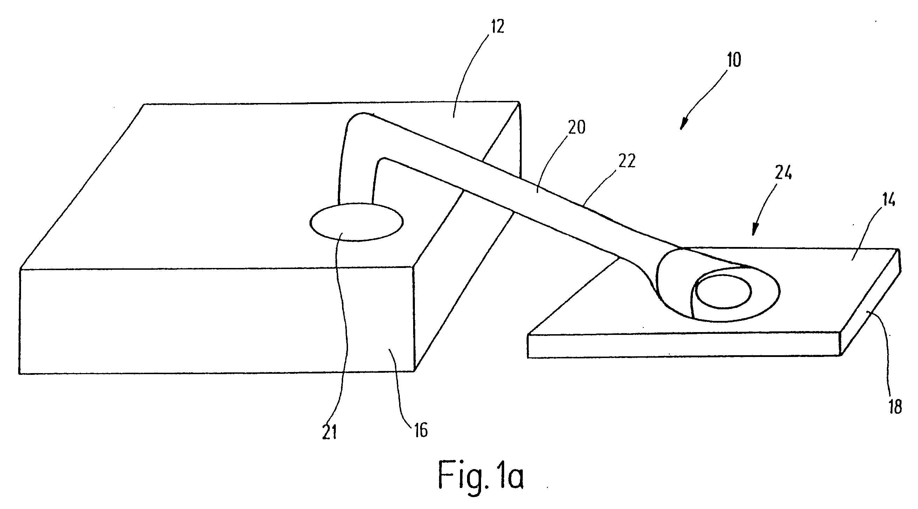

Figur 1a zeigt eine elektrische Verbindung 10 zwischen einer ersten Kontaktfläche 12 und einer zweiten Kontaktfläche 14. Die Kontaktfläche 12 ist auf einem Substrat 16 und die Kontaktfläche 14 auf einem Substrat 18 angeordnet. Die elektrische Verbindung 10 wird in bekannter Weise durch ein Bonden (Ball-Wedge-Bonden) hergestellt. Hierzu wird mittels einer nicht dargestellten Drahtbondeinrichtung ein Kontaktdraht 20 an seinem freien Ende zunächst erwärmt, so daß es zur Ausbildung einer Kugel 21 kommt. Diese Kugel 21 (Ball) wird mittels eines Kapillarmundstückes der Drahtbondeinrichtung auf die erste Kontaktfläche 12 gedrückt, so daß es an der Grenzfläche zwischen der, dann plastisch verformten Kugel 21 und der Kontaktfläche 12 zum Entstehen von atomaren Bindungskräften kommt. Nachfolgend wird die Drahtbondeinrichtung in Richtung der zweiten Kontaktfläche 14 bewegt, wobei es zur Ausbildung einer Schleife (Loop) 22 des Kontaktdrahtes 20 kommt. Auf der zweiten Kontaktfläche 14 wird der Kontaktdraht 20 mittels des Kapillarmundstückes angedrückt und plastisch verformt, so daß es zur Entstehung atomarer Bindungskräfte zwischen dem Kontaktdraht 20 und der zweiten Kontaktfläche 14 kommt. Durch die plastische Verformung des Kontaktdrahtes 20 (Stitch) über das Kapillarmundstück wird gleichzeitig eine Sollbruchstelle erzeugt, an der der Kontaktdraht 20 nach Wegführen des Kapillarmundstückes reißt. Die Ausbildung der zweiten Kontaktstelle 24 (Wedge) besitzt eine im Verhältnis geringe Berührungsfläche zwischen dem Kontaktdraht 20 und der Kontaktfläche 14. Hierdurch ist die Kontaktstelle 24 anfällig gegen ein Lösen des Kontaktdrahtes 20 von der Kontaktfläche 14. Insbesondere wenn die Kontaktfläche 14 aus einem schlecht bondbaren Material besteht, ergeben sich große Kontaktprobleme.

Die in Figur 1a gezeigte elektrische Verbindung 10 ist mittels eines bekannten Bondverfahrens (Ball-Wedge-Verfahren) hergestellt. Das Herstellen derartiger elektrischer Verbindungen 10 wird beispielsweise beim Kontaktieren von Mikrochips mit Mikrohybridbauelementen verwendet.

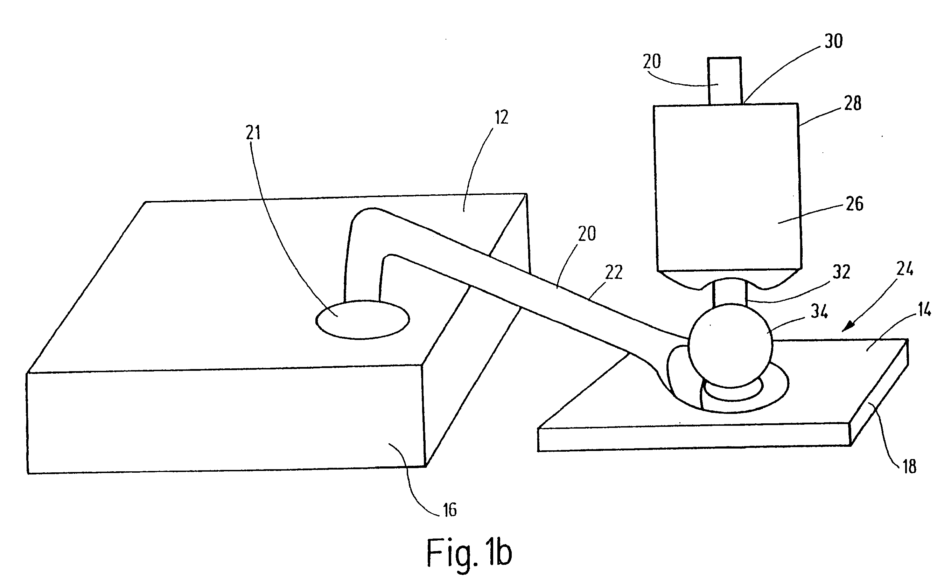

Anhand der Figuren 1b bis 1h wird das erfindungsgemäße Verfahren zur Herstellung der elektrischen Verbindung 10 verdeutlicht, wobei dieses von einer bereits hergestellten elektrischen Verbindung gemäß Figur 1a ausgeht. In den nachfolgenden Figuren sind gleiche Teile wie in Figur 1a immer mit gleichen Bezugszeichen versehen und nicht nochmals erläutert.

Figur 1b zeigt schematisch ein Kapillarmundstück 26 einer Drahtbondeinrichtung 28. Das Kapillarmundstück 26 besitzt eine Durchgangsöffnung 30, durch die der Kontaktdraht 20 geführt ist. Mittels geeigneter Vorschubeinrichtungen ist der Kontaktdraht 20 durch das Kapillarmundstück 26 bewegbar. Nach Herstellung der in Figur 1a gezeigten elektrischen Verbindung 10 wird der Kontaktdraht 20 in Richtung der zweiten Kontaktfläche 14 bewegt und an seinem freien Ende 32 mittels einer thermischen Energiequelle über seinen Schmelzpunkt erwärmt. Infolge einer Oberflächenspannung zieht sich die Schmelze des Kontaktdrahtes 20 zu einer Kugel 34 zusammen. Das Anschmelzen einer Kugel 34 an das Ende 32 erfolgt unmittelbar nach Herstellung der Verbindung zwischen dem Kontaktdraht 20 und der Kontaktfläche 14 gemäß Figur 1a. Hierdurch ist eine erneute Positionierung des Kapillarmundstückes 26 zur Kontaktstelle 24 nicht notwendig.

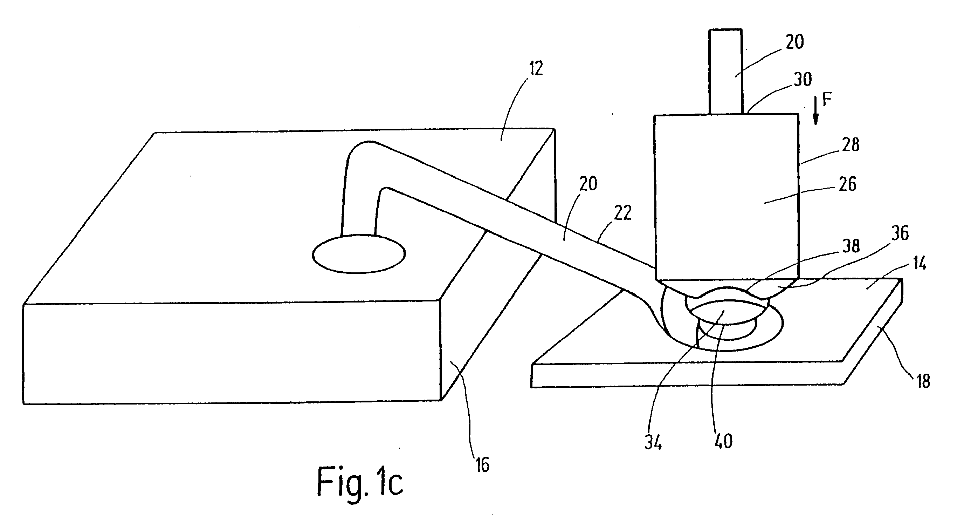

Gemäß dem in Figur 1c gezeigten nächsten Verfahrensschritt wird das Kapillarmundstück 26 mit Kraft und Ultraschall beaufschlagt. Die Kugel 34 wird hierdurch gestaucht und erfährt eine plastische Verformung. Entsprechend einer Formgebung des Kapillarmundstückes 26 kann die plastische Verformung der Kugel 34 beeinflußt werden. In dem gezeigten Ausführungsbeispiel besitzt das Kapillarmundstück 26 an seiner der Kontaktfläche 14 zugewandten Stirnseite einen umlaufenden Ringwulst 36, der einen Innenkegel 38 umgreift.

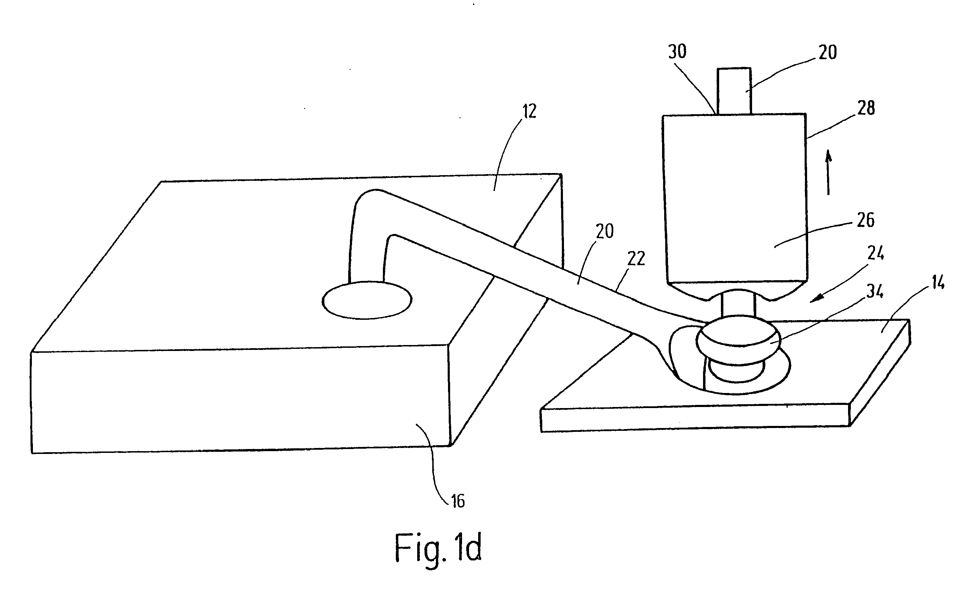

Entsprechend der Formgebung dieses Innenkegels 38 erfolgt die plastische Verformung der Kugel 34. Durch Aufbringen der Kontaktkraft F zusammen mit Ultraschallenergie entstehen zwischen der Kugel 34 und vom Zentrum 40 der Verbindungsstelle 24 beginnend, bis zum Wedge hinreichend atomare Bindungskräfte, so daß die verformte Kugel 34 während eines, in Figur 1d verdeutlichten, Wegführens von der Kontaktfläche 14 an der Kontaktstelle 24 haften bleibt.

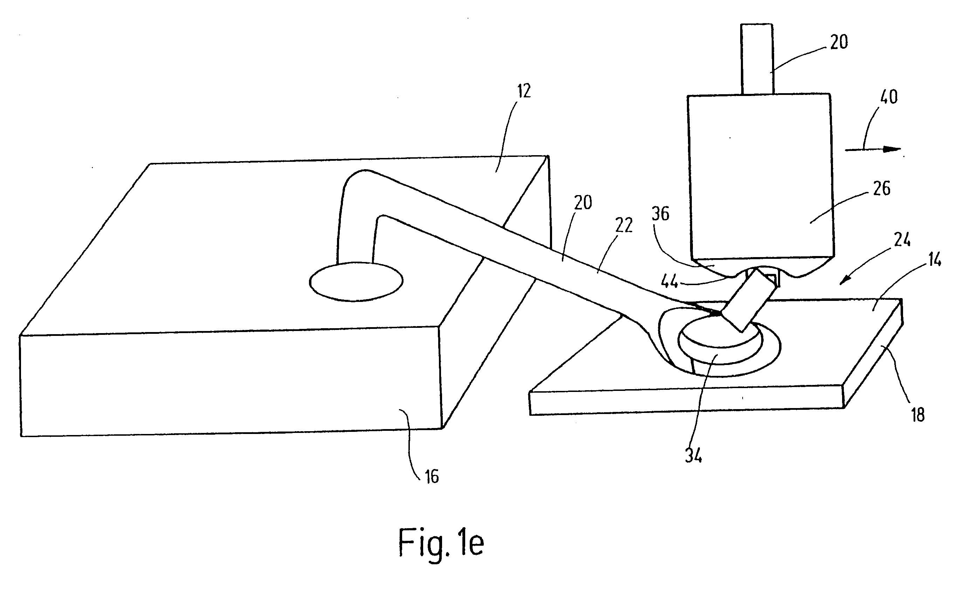

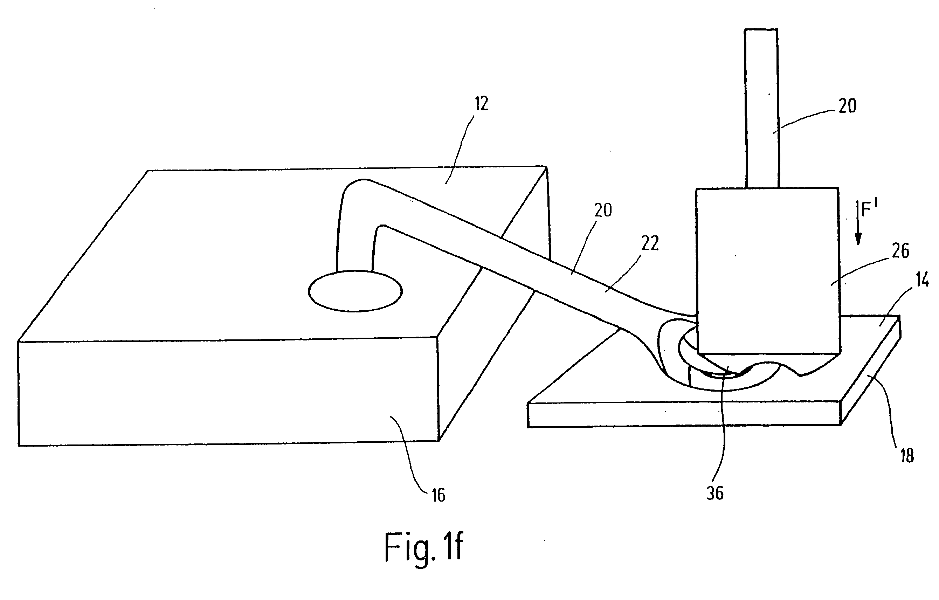

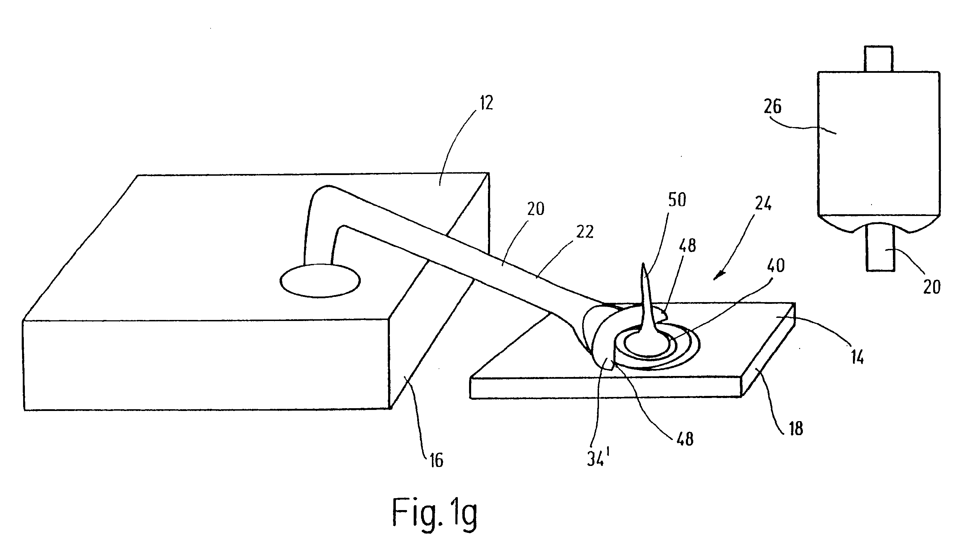

In einem nächsten, in Figur 1e verdeutlichten Verfahrensschritt wird das Kapillarmundstück 26 seitlich von der Kontaktstelle 24 wegbewegt. Diese Bewegung ist mit einem Pfeil 40 angedeutet. Gegebenenfalls kann das Abheben des Kapillarmundstückes 26 von der Kontaktstelle 24 (Figur 1d) mit der seitlichen Bewegung 40 überlagert sein. Die Bewegung 40 ist so gerichtet, daß deren Richtungsvektor in etwa fortgesetzt einer Längserstreckung des in der Schleife 22 verlegten Kontaktdrahtes 20 liegt. Die Bewegungsrichtung 40 wird solange beibehalten, bis ein Scheitelpunkt 44 des Ringwulstes 36 des Kapillarmundstückes 26 eine gedachte, durch die verformte Kugel 34 laufende Senkrechte (achsenparallel zum Kapillarmundstück 26 verlaufende Senkrechte) passiert hat. Anschließend wird das Kapillarmundstück 26, wie Figur 1f verdeutlicht, in Richtung der Kontaktfläche 14 bewegt, so daß der Ringwulst 36 auf die plastisch verformte Kugel 34 auftrifft. Entsprechend der aufgebrachten Kontaktkraft F' und unter Einwirkung von Ultraschall erfolgt eine weitere plastische Verformung der Kugel 34 durch die äußere Mantelfläche des Ringwulstes 36. Die Kugel 34 erfährt hierbei eine Verformung nach Art eines Schnitzes. Die Verformung der Kugel 34 erfolgt soweit, bis der Schnitz 34' seitlich über den bereits mit der Kontaktfläche 14 kontaktierten Kontaktdraht 20 übersteht und in zusätzlichen Verbindungsbereichen 48 in Berührungskontakt mit der Kontaktfläche 14 gelangt. Durch diese Art der Verformung werden atomare Bindungskräfte zwischen dem geformten Schnitz 34' und der Kontaktfläche 14 erzeugt, so daß dieses fest anhaftet. Wie Figur 1g verdeutlicht, überspannt der Schnitz 34 nach Wegbewegung des Kapillarmundstückes 26 den Kontaktdraht 20 im Bereich der Kontaktstelle 24 und hält diesen laschenförmig fest. Der Schnitz 34 bildet quasi eine Zugentlastung zur Sicherung der Kontaktstelle 24 für den Kontaktdraht 20. Im Zentrum 40 der Kontaktstelle 24 ist der durch Fortbewegen des Kapillarmundstückes 26 abgerissene restliche Draht als spitzenförmige Erhöhung 50 erkennbar. Diese bildet einen zusätzlichen Formschluß mit dem Kontaktdraht 20 im Bereich der Kontaktstelle 24.

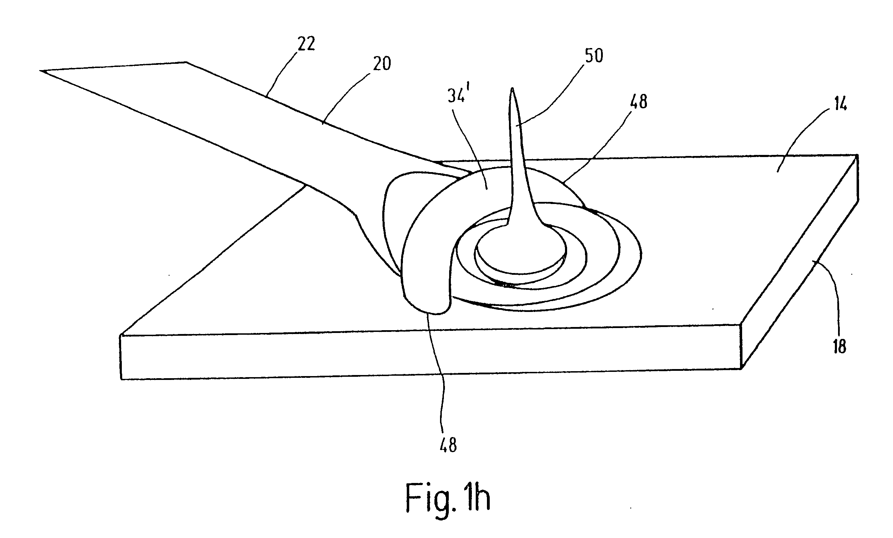

In Figur 1h ist eine vergrößerte Darstellung der Kontaktstelle 24 nach Abschluß der Herstellung der elektrischen Verbindung 10 mit der zusätzlichen Kontaktsicherung durch den Schnitz 34' gezeigt. Es wird deutlich, daß der Schnitz 34' bestimmte Formmerkmale aufweist, die sich im wesentlichen aus der Größe der Kugel 34 (Figur 1b) und der Größe und der Art der Bondparameter (Figur 1f) sowie der Formgestaltung des Ringwulstes 36 des Kapillarmundstückes 26 ergeben. Da sowohl die Formgestalt des Kapillarmundstückes 26, die Größe der Bondkräfte sowie die Größe der Kugel 34 bekannt beziehungsweise einstellbar sind, lassen sich Schnitze 34' in reproduzierbarer Formgestalt erzielen. Nach Abschluß der Herstellung der Kontaktstelle 24 kann der Schnitz 34' durch eine nicht dargestellte optische Überwachungseinheit vermessen werden. Durch Vergleich der gemessenen Form des Schnitzes 34' mit einer zuvor abgespeicherten Form lassen sich Rückschlüsse auf die Qualität der Kontaktstelle 24 ziehen. Bei Übereinstimmung der Form des Schnitzes 34' mit der erwarteten Form läßt sich auf eine einwandfreie, das heißt kontaktsichere sowie zusätzlich gesicherte Kontaktstelle 24 schließen, so daß eine sogenannte Null-Fehler-Herstellung der Kontaktstelle 24 möglich ist. Insbesondere bei Einsatz elektrischer Verbindungen an Mikrochips bei sicherheitstechnischen Anlagen lassen sich so fehlerfreie Gebrauchswerte vorhersagen.

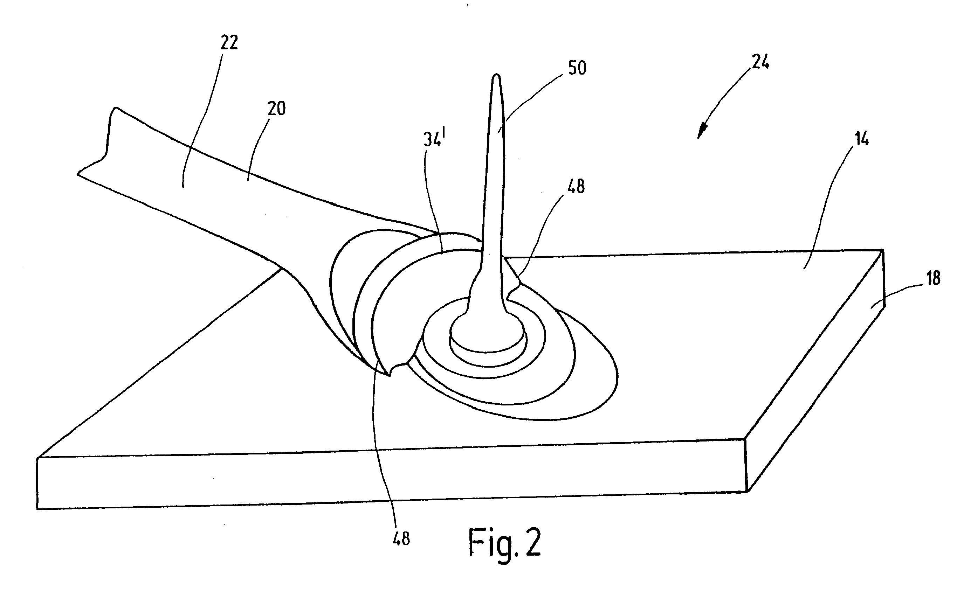

Die Erfindung beschränkt sich selbstverständlich nicht auf das in Figur 1 dargestellte Ausführungsbeispiel. So kann insbesondere die Form des Schnitzes 34' unterschiedlich gewählt sein. Anhand der Figuren 2 bis 6 werden verschiedene Ausführungsformen des Schnitzes 34' verdeutlicht. Eine Einstellung der Form des Schnitzes 34' ist beispielsweise durch eine andere Formgebung des Kapillarmundstückes 26 und eine andere Plazierung des Kapillarmundstückes 26 während der Verformung der Kugel 34 zu dem Schnitz 34' möglich. Darüber hinaus kann über die Einstellung von allgemeinen Bondparametern, wie beispielsweise die Kraft F beziehungsweise die Höhe und Intensität der Ultraschallenergie auf die Ausbildung des Schnitzes 34, und dessen Kontaktierung mit der Kontaktfläche 14 Einfluß genommen werden.

Insbesondere ist nach weiteren Ausführungsbeispielen möglich, eine Vertiefung zwischen der Spitze 50 und dem Schnitz 34' weniger ausgeprägt auszubilden. Das heißt, der Schnitz 34' geht über eine im Verhältnis flache Vertiefung in die Spitze 50 über, wodurch der Formschluß zwischen dem Kontaktdraht 20 und dem Schnitz 34' im Beispiel Kontaktstelle 24 beeinflußt, insbesondere verbessert werden kann.

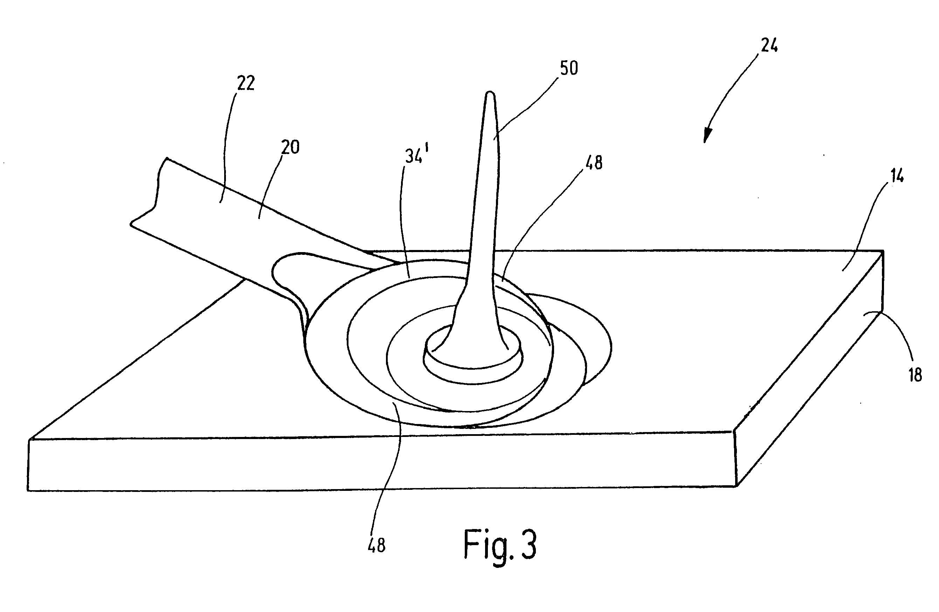

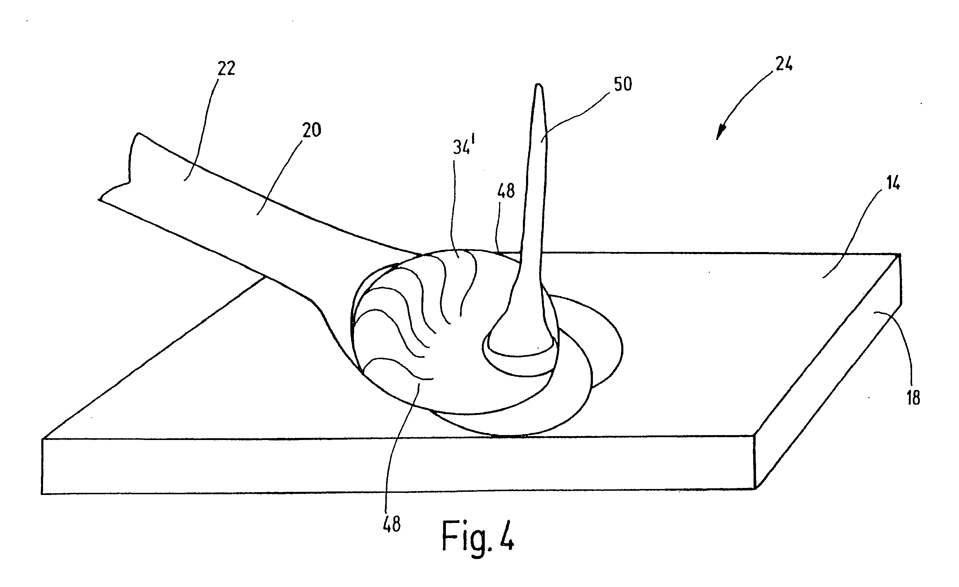

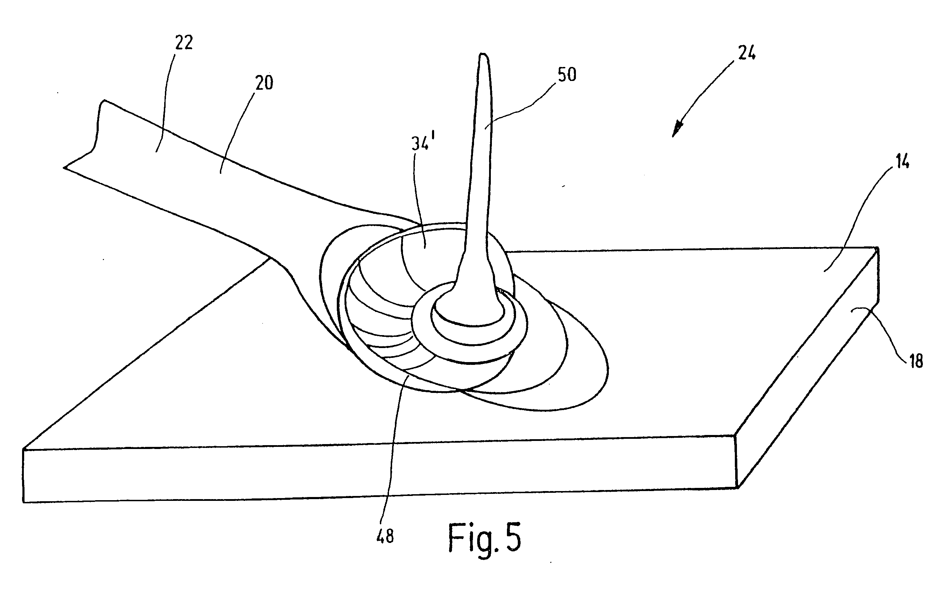

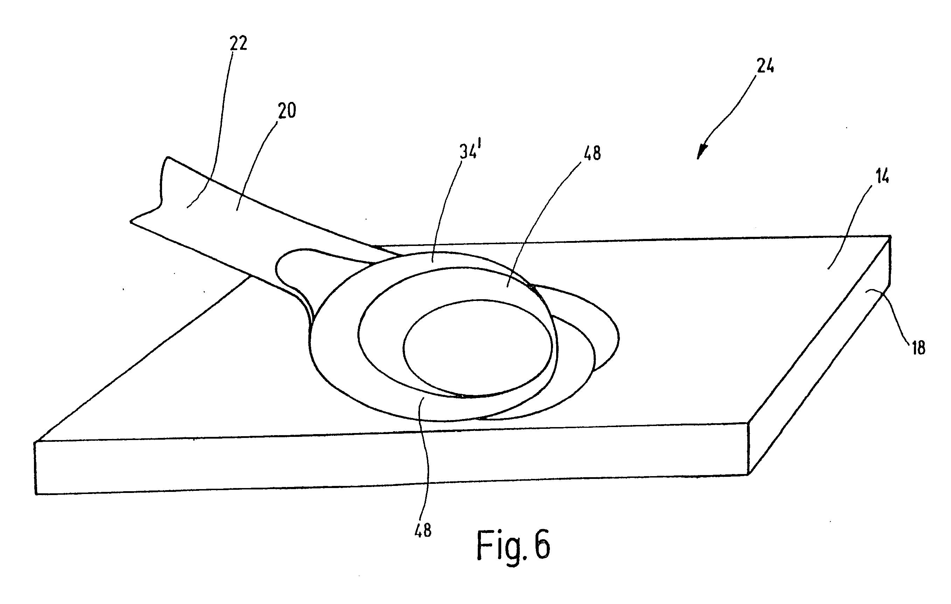

Figur 2 zeigt hierzu beispielhaft einen Schnitz 34' der wulstförmig ausgebildet ist. Im Gegensatz hierzu ist der Schnitz 34' gemäß Figur 3 flacher ausgebildet und geht in die Spitze 50 materialmäßig über. Gemäß dem in Figur 4 gezeigten Ausführungsbeispiel ist der Schnitz 34' nochmals flacher ausgebildet, so daß dieser fast scheibenförmig ausgebildet ist und ebenfalls materialmäßig in die Spitze 50 übergeht. Eine weitere Ausführungsvariante zeigt Figur 5, bei der der Schnitz 34' eine flache Muldenform aufweist, wobei wiederum der Schnitz 34' materialmäßig mit der Spitze 50 verbunden ist. Schließlich ist in Figur 6 eine Ausführungsvariante des Schnitzes 34' gezeigt, bei der der Schnitz 34' als im wesentlichen flache Scheibe ausgebildet ist, die eine wulstförmige Verdickung in Richtung des Kontaktdrahtes 20 aufweist. Die Spitze 50 ist hier durch entsprechende Verformung der Kugel 34 materialmäßig in den Schnitz 34' mitverformt. Dies kann durch entsprechende Ausbildung des Kapillarmundstückes 26 und Plazierung des Kapillarmundstückes 26 während der Verformung zu dem Schnitz 34' realisiert werden.

Ferner ist durch Einstellung der Bondparameter und/oder der Platzierungsparameter des Kapillarmundstückes 26 während der Ausformung des Schnitzes 34' möglich, den Schnitz 34' als im wesentlichen quaderförmiges Gebilde mit einer definierten Erstreckung in x-Richtung, y-Richtung sowie z-Richtung zu modulieren. Durch einstellbare Parameter während der Verformung der Kugel 34 zu dem "quaderförmigen" Schnitz 34' lassen sich exakt reproduzierbare Abmessungen in x-, y- und z-Richtung einstellen. Über eine anschließende optische, insbesondere automatisch optische Prüfung der Kontaktstelle 24 kann so in einfacher und effektiver Weise die Kontaktstelle 24 auf Fehlerfreiheit untersucht werden.

## Patentansprüche

1. Verfahren zur Herstellung einer elektrischen Verbindung zwischen einer ersten Kontaktfläche und einer zweiten Kontaktfläche, wobei mittels einer Drahtbondeinrichtung zwischen den Kontaktflächen ein Kontaktdraht angeordnet wird, indem der Kontaktdraht mit der ersten Kontaktfläche kontaktiert wird und anschließend zu der zweiten Kontaktfläche geführt, mit dieser kontaktiert und anschließend durch die Drahtbondeinrichtung abgetrennt wird, wobei mittels der Drahtbondeinrichtung (28) nach Abtrennen des Kontaktdrahtes (20) von der zweiten Kontaktfläche (14) die Kontaktstelle (24) mit einer zusätzlichen Kontaktsicherung (34') mittels des Kontaktdrahtes (20) versehen wird, wobei die zusätzliche Kontaktsicherung (34') durch eine auf die Kontaktstelle (24) aufgebrachte und anschließend mittels der Drahtbondeinrichtung (28) verformten Kugel (34) eines nach der Kontaktierung der zweiten Kontaktfläche (14) freien Endes (32) des Kontaktdrahtes (20) erfolgt, und wobei nach einer plastischen Vorverformung der Kugel (34) ein Kapillarmundstück (26) der Drahtbondeinrichtung (28) seitlich von der Kontaktstelle (24), mit einem der Längserstreckung des Kontaktdrahtes (20) zwischen den Kontaktflächen (12, 14) fortgesetzten Richtungsvektor (40), wegbewegt wird und anschließend auf die vorgeformte Kugel (34) zur Ausbildung der Kontaktsicherung (34') zu deren plastischen Endverformung bewegt wird.

2. Verfahren nach einem der vorhergehenden Ansprüche,
**dadurch gekennzeichnet, daß** die Kugel (34) mit der Drahtbondeinrichtung (28) so zu der Kontaktsicherung (34') verformt wird, daß diese die Kontaktstelle (24) überlappt und wenigstens einen zusätzlichen Verbindungsbereich (48) mit der Kontaktfläche (14) ausbildet.

3. Verfahren nach einem der vorhergehenden Ansprüche,
**dadurch gekennzeichnet, daß** das Ende (32) des Kontaktdrahtes (20) zur Ausbildung der Kugel (34) über seinem Schmelzpunkt erwärmt wird.

4. Verfahren nach einem der vorhergehenden Ansprüche,
**dadurch gekennzeichnet, daß** die Kugel (34) zunächst auf einem Zentrum (40) der Kontaktstelle (24) plastisch vorverformt wird.

5. Verfahren nach einem der vorhergehenden Ansprüche,
**dadurch gekennzeichnet, daß** die Bewegung (40) des Kapillarmundstückes (26) solange beibehalten wird, bis ein Scheitelpunkt (44) eines Ringwulstes (36) des Kapillarmundstückes (26) eine gedachte, durch die vorgeformte Kugel (34) achsenparallel zum Kapillarmundstück (26) verlaufende senkrechte passiert hat.

6. Verfahren nach einem der vorhergehenden Ansprüche,
**dadurch gekennzeichnet, daß** die Formgebung der Kontaktsicherung (34') durch Programmierung der Drahtbondeinrichtung (28) reproduzierbar einstellbar ist.

7. Verfahren nach Anspruch 6, **dadurch gekennzeichnet, daß** die Formgebung der Kontaktsicherung (34') durch Einstellung der Bondparameter und/oder der Plazierungsparameter der Drahtbondeinrichtung (28) wählbar reproduzierbar einstellbar ist.

8. Verfahren nach einem der vorhergehenden Ansprüche,
**dadurch gekennzeichnet, daß** die Kontaktsicherung (34') nach Wegbewegen der Drahtbondeinrichtung (28) optisch, insbesondere automatisch optisch überprüft wird.

## Claims

1. Method for producing an electrical connection between a first contact area and a second contact area, a contact wire being arranged between the contact areas by means of a wire bonding device, in that the contact wire is bonded with the first contact area and subsequently led to the second contact area, bonded with the latter and subsequently detached by the wire bonding device, wherein, after detaching the contact wire (20) from the second contact area (14), the wire bonding device (28) is used to provide the contact pad (24) with additional contact protection (34') by means of the contact wire (20), wherein the additional contact protection (34') takes place by a ball (34) of an end (32) of the contact wire (20) that is free after the bonding of the second contact area (14) being applied to the contact pad (24) and subsequently deformed by means of the wire bonding device (28), and wherein, after a preliminary plastic deformation of the ball (34), a capillary mouthpiece (26) of the wire bonding device (28) is moved laterally away from the contact pad (24), with a directional vector (40) that continues the longitudinal extent of the contact wire (20) between the contact areas (12, 14), and is subsequently moved onto the preformed ball (34) to form the contact protection (34') for its final plastic deformation.

2. Method according to Claim 1, **characterized in that** the ball (34) is deformed by the wire bonding device (28) to form the contact protection (34') in such a way that the latter overlaps the contact pad (24) and forms at least one additional connecting region (48) with the contact area (14).

3. Method according to one of the preceding claims,
**characterized in that** the end (32) of the contact wire (20) is heated above its melting point to form the ball (34).

4. Method according to one of the preceding claims,
**characterized in that** the ball (34) is first preliminarily plastically deformed on a centre (40) of the contact pad (24).

5. Method according to one of the preceding claims,
**characterized in that** the movement (40) of the capillary mouthpiece (26) is maintained until an apex point (44) of an annular bead (36) of the capillary mouthpiece (26) has passed an imaginary perpendicular that extends through the preformed ball (34) axially parallel to the capillary mouthpiece (26).

6. Method according to one of the preceding claims,
**characterized in that** the shaping of the contact protection (34') can be reproducibly set by programming the wire bonding device (28).

7. Method according to Claim 6, **characterized in that** the shaping of the contact protection (34') can be reproducibly set in a selectable manner by setting the bonding parameters and/or the placement parameters of the wire bonding device (28).

8. Method according to one of the preceding claims,
**characterized in that** the contact protection (34') is optically checked, in particular automatically optically checked, after the wire bonding device (28) is moved away.

## Revendications

1. Procédé pour réaliser une connexion électrique entre une première surface de contact et une seconde surface de contact, selon lequel à l'aide d'une installation de liaison de fil entre les surfaces de contact on installe un fil de contact en ce que l'on met le fil de contact en liaison avec la première surface de contact et ensuite on le conduit vers la seconde surface de contact pour le mettre en contact avec celle-ci et enfin on coupe par l'installation de liaison par fil,
procédé selon lequel
à l'aide de l'installation de liaison par fil (28), après coupure du fil de contact (20) de la première surface de contact (14), on munit le point de contact (24) d'une fixation de contact supplémentaire (24) à l'aide du fil de contact (20),
la fixation de contact supplémentaire (34') étant réalisée par une bille (34) appliquée sur le point de contact (24) est ensuite déformée par l'installation de fil de liaison (28), cette bille étant celle de l'extrémité libre (32) du fil de contact (20) après la mise en contact de la seconde surface de contact (14) et
après une déformation plastique préalable de la bille (34) on écarte un embout capillaire (26) de l'installation de liaison par fil (28), latéralement du point de contact (24) selon un vecteur de direction (40) fixé selon l'extension longitudinale du fil de contact (20) entre les surfaces de contact (12, 14) et ensuite on le déplace sur la bille préformée (34) pour réaliser la fixation de contact (34') par sa déformation plastique finale.

2. Procédé selon la revendication précédente,
**caractérisée en ce que**
la bille (34) est déformée par l'installation de liaison par fil (28) pour former une fixation de contact (34') pour que celle-ci chevauche le point de contact (24) et forme au moins une zone de liaison supplémentaire (48) avec la surface de contact (14).

3. Procédé selon l'une des revendications précédentes,
**caractérisé en ce que**
l'extrémité (32) du fil de contact (20) est chauffée au-delà de son point de fusion pour former la bille (34).

4. Procédé selon l'une des revendications précédentes,
**caractérisé en ce qu'**
on effectue une déformation plastique préalable de la bille (34) tout d'abord au centre (40) du point de contact (24).

5. Procédé selon l'une des revendications précédentes,
**caractérisé en ce qu'**
on conserve le mouvement (40) de l'embout capillaire (26) jusqu'à ce qu'un sommet (44) d'un bourrelet annulaire (36) de l'embout capillaire (26) soit passé sur une verticale géométrique traversant la bille préformée (34), d'axe parallèle à l'embout capillaire (26).

6. Procédé selon l'une des revendications précédentes,
**caractérisé en ce que**
la mise en forme de la fixation de contact (34') est réglable de manière reproductible par programmation de l'installation de liaison par fil (28).

7. Procédé selon la revendication 6,
**caractérisé en ce que**
la mise en forme de la fixation de contact (34') se fait par réglage du paramètre de liaison et/ou du paramètre de placement de l'installation de liaison par fil (28) de façon réglable et reproductible sélectivement.

8. Procédé selon l'une des revendications précédentes,
**caractérisé en ce que**
la fixation de contact (34') est contrôlée optiquement et notamment de manière automatique optiquement après dégagement de l'installation de liaison par fil (28).
